(19) Europäisches Patentamt
European Patent Office
Office européen des brevets

(11) EP 2 817 149 B1

(12) # EUROPÄISCHE PATENTSCHRIFT

(45) Veröffentlichungstag und Bekanntmachung des Hinweises auf die Patenterteilung:
**29.06.2016 Patentblatt 2016/26**

(21) Anmeldenummer: **12813338.6**

(22) Anmeldetag: **19.12.2012**

(51) Int Cl.:
***B32B 17/10*** *(2006.01)* ***C03C 17/36*** *(2006.01)*

(86) Internationale Anmeldenummer:
**PCT/EP2012/076197**

(87) Internationale Veröffentlichungsnummer:
**WO 2013/124017 (29.08.2013 Gazette 2013/35)**

(54) **MEHRSCHICHTAUFBAU ALS REFLEKTOR MIT ERHÖHTER MECHANISCHER STABILITÄT**
MULTILAYER STRUCTURE AS REFLECTOR WITH INCREASED MECHANICAL STABILITY
STRUCTURE MULTICOUCHE SERVANT DE RÉFLECTEUR À STABILITÉ MÉCANIQUE ACCRUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.02.2012 US 201213400159**

(43) Veröffentlichungstag der Anmeldung:
**31.12.2014 Patentblatt 2015/01**

(73) Patentinhaber: **Covestro Deutschland AG**
**51373 Leverkusen (DE)**

(72) Erfinder:
- **OSER, Rafael**
**47800 Krefeld (DE)**
- **KUHLMANN, Timo**
**42799 Leichlingen (DE)**

(74) Vertreter: **Levpat**
**c/o Covestro AG**
**Alfred-Nobel-Straße 10**
**40789 Monheim am Rhein (DE)**

(56) Entgegenhaltungen:
**WO-A1-2011/045121**

- **"Society of Vacuum Coaters, 52nd,", 2009, XP002694122, Seiten 473-477, in der Anmeldung erwähnt das ganze Dokument**

EP 2 817 149 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft einen Mehrschichtaufbau zur Anwendung als Spiegel/Reflektor, im Bereich der CPV (concentrating photovoltaics) und CSP (concentrating solar power). Der Mehrschichtaufbau enthält eine Substratschicht, eine Barriereschicht, eine metallische Reflektorschicht, eine optionale oxidische Schicht und eine weitere Schicht, die eine Plasmapolymerschicht oder eine hochbrechende Metalloxidschicht sein kann. Des Weiteren wird der zuvor beschriebene Aufbau durch ein erfindungsgemäßes Deckschichtsystem vor Witterungseinflüssen und mechanischer Beanspruchung geschützt.

Silberspiegel für Anwendungen im CPV- und CSP-Bereich sind bereits bekannt.

WO 2000007818 beschreibt Silberspiegel basierend auf einem polymeren Substrat mit einer hierauf unmittelbar aufgebrachten Silberschicht, welche wiederum durch eine unmittelbar auf diese aufgebrachte und fest mit dieser verbundenen polymeren Schutzschicht überlagert ist. Auf diese Polymerschicht ist ein UV absorbierender polymerer Film aufgetragen.

US 6078425 beschreibt Mehrschichtspiegel enthaltend reflektive Schichten aus Aluminium und Silber, wobei eine Haftungsschicht aus Nickel und/oder Chromlegierungen oder Nitriden auf die Aluminiumoberfläche abgeschieden wird. Die Silberschicht wird durch eine Schicht aus Nickel und/oder Chromlegierungen oder Nitriden und einer oder mehreren Schichten aus Metalloxiden geschützt.

Ausgehend von den bekannten Systemen, die aufgebaut sind aus einer Metallschicht (Al, oder Cu), einer Silberreflexionsschicht, entweder einer transparente Schutzschicht aus Aluminiumoxid oder einer Siliziumnitridschicht mit darauf aufgebrachten SiO2 und Tantaloxidschichten soll in Society of Vacuum Coaters (2009), 52nd, 473-477 das komplexe Schutzschichtsystem ersetzt werden, um eine Massenproduktion mittels Kurztaktmetallisierungsanlagen zu realisieren. Hierbei sollen die hergestellten Schichtaufbauten nach wie vor über eine ausreichende Reflektivität und Witterungseigenschaften verfügen.

Society of Vacuum Coaters (2009), 52nd, 473-477 offenbart daher spezielle Mehrschichtaufbauten mit erhöhter Reflektivität und Witterungsstabilität. Es werden hierbei Schichtaufbauten beschrieben, die ein Kunststoffsubstrat, eine Metallschicht, einen darauf aufgebrachten Silberreflektor und einen Plasmasiloxan Topcoat aufweist. Hierbei erreicht der beschriebene Aufbau jedoch nicht die geforderten Anforderungen.

Aus Concentrating Photovoltaic Conference 7 (CPV 7), Las Vegas, April 2011 ist die Notwendigkeit bekannt, für CPV-Anwendungen hochreflektive Silberspiegel mit hoher Langlebigkeit zur Verfügung zu stellen. In diesem Zusammenhang werden verschiedene Lösungsansätze in allgemeiner Form vorgestellt. Dabei wurde unter anderem ein System vorgestellt, welches folgenden allgemeinen Aufbau besitzt: Substrat, Metall, Silberreflektor, Metalloxid, HMDSO.

In SVC/Society of Vacuum Coaters 2009, Optics 021 wird das Plasmacoating als einfache Methode zur Herstellung von metallischen reflektierenden und korrosionsbeständigen Mehrschichtsystemen beschrieben und Versuche durchgeführt. Es wird beschrieben, dass nach dieser Methode bislang keine Aluminiumoxidschutzschichten in den oben beschriebenen Kurztaktbeschichtungen eingesetzt werden.

Für die Anwendung von Reflektoren im CPV- und CSP-Bereich reicht das Eigenschaftsprofil der oben genannten Systeme jedoch insbesondere im Hinblick auf den Erhalt einer hohen Reflektivität während der Lebensdauer im Außeneinsatz nicht aus. Insbesondere ist nach wie vor die negative Beeinflussung der Reflektivität durch verstärkte witterungsbedingte Korrosion noch nicht zufriedenstellend für einen kommerziellen Einsatz gelöst. Weiterhin sollen diese Mehrschichtsysteme auf eine einfache und kostengünstige Weise in großer Stückzahl hergestellt werden können.

Den zuvor genannten Ausführungsformen ist gemein, dass derartige Silberspiegel in der Regel frontseitig mit einer Glasplatte abgedeckt werden, um den darunter befindlichen Aufbau des Reflektors vor äußeren Einflüssen wie Witterung oder mechanischer Beanspruchung durch Abrieb zu schützen. Je nach Dicke und Typ der verwendeten Glasplatte wird die Reflektivität des Reflektors reduziert, wodurch derartige Aufbauten an Effektivität und einhergehend an Wirtschaftlichkeit verlieren. Des Weiteren bietet der Verzicht einer Glasplatte eine größere Designfreiheit für das resultierende Gesamtbauteil.

Der Verbund aus Reflektor und Glasplatte wird am Rand zusätzlich versiegelt um ein Eindringen von Feuchtigkeit und somit die Korrosion der reflektierenden Schicht zu unterbinden. Des Weiteren wird die Reflektivität des Aufbaus durch anhaftendes Wasser im Zwischenraum zwischen Reflektor und Glasplatte reduziert. Zur Versiegelung des Aufbaus sind zusätzliche Arbeitsschritte erforderlich, die die Kosten des Aufbaus zusätzlich erhöhen.

Aufgabe der vorliegenden Erfindung ist es daher, ein Mehrschichtsystem zur Verfügung zu stellen, welches über eine über den Lebenszyklus konstant hohe Reflektivität verfügt, wobei der resultierende Reflektor nicht mehr durch eine Glasscheibe vor äußeren Einflüssen geschützt werden muss. Die reflektierende Schicht befindet sich hierbei auf einem Träger und ist direkt der Sonne zugewandt. Einfallende Strahlung wird so direkt reflektiert ohne das Trägermaterial zu passieren. Derartige Reflektoren-Anordnungen werden als first surface mirrors bezeichnet.

Weiterhin weist das Mehrschichtsystem eine hohe Formstabilität, eine geringe Rissbildung sowie eine niedrige Oberflächenrauigkeit auf und genügt hierdurch den Anforderungen der DIN EN 62108 bezüglich der Klimawechselstabilität (Kapitel 10.6, 10.7 und 10.8).

Die Aufgabe wurde gelöst durch einen erfindungsmäßen Mehrschichtaufbau, der eine Substratschicht A, eine Barriereschicht B, eine metallische Reflektorschicht C, eine optionale Schicht D, eine Plasmapolymerschicht E sowie eine Deckschicht enthaltend anorganische Bestandteile umfasst und die Deckschicht keinen UV Absorber enthält.

Gegenstand der vorliegenden Erfindung ist daher ein Mehrschichtaufbau enthaltend die nachfolgenden Schichten:

Schicht A: eine Substratschicht, ausgewählt aus einem thermoplastischen Kunststoff, Metall oder Glas

Schicht B: eine Barriereschicht, ausgewählt aus Titan oder der Gruppe der Edelmetalle, wobei Gold, Palladium, Platin, Vanadium, Tantal bevorzugte Edelmetalle sind.

Schicht C: metallische Reflektorschicht, bevorzugt aus Silber oder Silberlegierungen, wobei die Silberlegierung Anteile von kleiner 10 Gew.-% an Gold, Platin, Palladium und/oder Titan aufweist, sowie Aluminium.

Schicht D: optional eine oxidische Schicht, ausgewählt aus Aluminiumoxid (AlOx), Titandioxid, $SiO_2$, $Ta_2O_5$, $ZrO_2$, $Nb_2O_5$ und HfO.

Schicht E:

a) Plasmapolymerschicht (Korrosionsschutzschicht) abgeschieden aus Siloxanprecusoren; beispielsweise und bevorzugt genannte sind Hexamethyldisiloxan (HMDSO), Octamethylcyclotetrasiloxan (OMCTS), Octamethyltrissiloxan (OMTS), Tetraethylorthosilan (TEOS), und Tetrametyldisiloxan (TMDSO), Decamethylcyclopentasiloxan (DMDMS), Hexamethylcyclotrisiloxan (HMCTS), Trimethoxymethylsilan (TMOMS), Tetramethylcyclotetrasiloxan (TMCTS); besonders bevorzugt ist HMDSO,
oder
im Falle, dass Schicht D aus Aluminiumoxid oder SiO2 ist Schicht E

b) eine hochbrechende Metalloxidschicht, wobei die Metalloxide ausgewählt sind aus Titandioxid, $SiO_2$, $Ta_2O_5$, $ZrO_2$, $Nb_2O_5$ und HfO oder $SiO_2$ sein kann und optional eine weitere Schicht gemäß Schicht E (a), also eine Plasmapolymerschicht aufgebracht sein kann.

Schicht F:

(im Folgenden auch als anorganische Deckschicht bezeichnet) wobei Schicht F Sol-Gel-Lacke sind, die durch Hydrolyse wässriger Dispersionen von kolloidem Siliziumdioxid und einem Organoalkoxysilan und/oder einem Alkoxysilan oder Mischungen aus Organoalkoxysilanen der allgemeinen Formel RSi(OR')3 und/oder Alkoxysilanen der allgemeinen Formeln Si(OR')4 herstellt werden, wobei in den Organoalkoxysilan(en) der allgemeinen Formel RSi(OR')3 R für einen monovalenten C1 bis C6 - Alkyl-Rest oder für einen ganz oder teilweise fluorierten C1 - C6 - Alkylrest, für eine Vinyl- oder eine Allyl-Einheit, einen Arylrest oder für ein C1 - C6 Alkoxygruppe steht.erhalten werden und wobei diese Schicht keinen UV-Absorber enthält.

**Schicht A:**

Schicht A ist ausgewählt aus einem thermoplastischen Kunststoff, Metall oder Glas.

Thermoplastische Kunststoffe für die Substratschicht sind bevorzugt Polycarbonat, Polystyrol, Styrol-Copolymere, aromatische Polyester wie Polyethylenterephthalat (PET), PET-Cyclohexandimethanol-Copolymer (PETG), Polyethylennaphthalat (PEN), Polybutylenterephthalat (PBT), cyclisches Polyolefin, Poly- oder Copolyacrylate und Poly- oder Copolymethacrylat wie z.B. Poly- oder Copolymethylmethacrylate (wie PMMA) sowie Copolymere mit Styrol wie z.B. transparentes Polystyrolacrylnitril (PSAN), thermoplastische Polyurethane, Polymere auf Basis von zyklischen Olefinen (z.B. TOPAS®, ein Handelsprodukt der Firma Ticona), Polycarbonat Blends mit olefinischen Copolymeren oder Pfropfpolymeren, wie beispielsweise Styrol/Acrylnitril Copolymeren. Besonders bevorzugt ist Polycarbonat, PET oder PETG. Insbesondere ist die Substratschicht aus Polycarbonat.

Polycarbonate im Sinn der vorliegenden Erfindung sind sowohl Homopolycarbonate, Copolycarbonate als auch Polyestercarbonate wie sie beispielsweise EP-A 1,657,281 sind.

Die Herstellung aromatischer Polycarbonate erfolgt z. B. durch Umsetzung von Diphenolen mit Kohlensäurehalogeniden, vorzugsweise Phosgen und/oder mit aromatischen Dicarbonsäuredihalogeniden, vorzugsweise Benzoldicarbonsäuredihalogeniden, nach dem Phasengrenzflächenverfahren, gegebenenfalls unter Verwendung von Kettenabbrechern, beispielsweise Monophenolen und gegebenenfalls unter Verwendung von trifunktionellen oder mehr als trifunktionellen Verzweigern, beispielsweise Triphenolen oder Tetraphenolen. Ebenso ist eine Herstellung über ein Schmelzepolymerisationsverfahren durch Umsetzung von Diphenolen mit beispielsweise Diphenylcarbonat möglich.

Diphenole zur Herstellung der aromatischen Polycarbonate und/oder aromatischen Polyestercarbonate sind vorzugsweise solche der Formel (I)

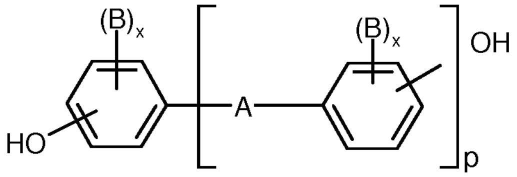

(I),

wobei

A eine Einfachbindung, $C_1$ bis $C_5$-Alkylen, $C_2$ bis $C_5$-Alkyliden, $C_5$ bis $C_6$-Cycloalkyliden, -O-, -SO-, - CO-, -S-, $-SO_2-$, $C_6$ bis $C_{12}$-Arylen, an das weitere aromatische gegebenenfalls Heteroatome enthaltende Ringe kondensiert sein können, oder ein Rest der Formel (II) oder (III)

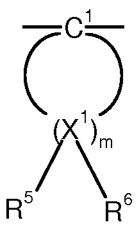

(II)

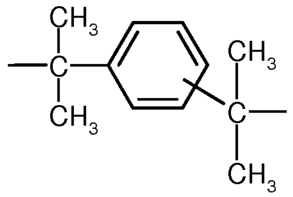

(III)

B jeweils $C_1$ bis $C_{12}$-Alkyl, vorzugsweise Methyl, Halogen, vorzugsweise Chlor und/oder Brom

x jeweils unabhängig voneinander 0, 1 oder 2,

p 1 oder 0 sind, und

$R^5$ und $R^6$ für jedes $X^1$ individuell wählbar, unabhängig voneinander Wasserstoff oder $C_1$ bis $C_6$-Alkyl, vorzugsweise Wasserstoff, Methyl oder Ethyl,

$X^1$ Kohlenstoff und

m eine ganze Zahl von 4 bis 7, bevorzugt 4 oder 5 bedeuten, mit der Maßgabe, dass an mindestens einem Atom $X^1$, $R^5$ und $R^6$ gleichzeitig Alkyl sind.

Für die Herstellung der Polycarbonate geeignete Diphenole sind beispielsweise Hydrochinon, Resorcin, Dihydroxydiphenyle, Bis-(hydroxyphenyl)-alkane, Bis(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, alpha-alpha'-Bis-(hydroxyphenyl)-diisopropylbenzole,Phtalimidine abgeleitet von Isatin- oder Phenolphthaleinderivaten sowie deren kernalkylierte und kernhalogenierte Verbindungen.

Bevorzugte Diphenole sind 4,4'-Dihydroxydiphenyl, 2,2-Bis-(4-hydroxyphenyl)-propan, 2,4-Bis-(4-hydroxyphenyl)-2-methylbutan, 1,1-Bis-(4-hdydroxyphenyl)-p-diisopropylbenzol, 2,2-Bis-(3-methyl-4-hydroxyphenyl)-propan, 2,2-Bis-(3-chlor-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan,

1,1-Bis-(3,5-dimethyl-4-hydroxyphenyl)-p-diisopropylbenzol, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-3,3,5-trimethylcyclohexan, und 2-Hydrocarbyl-3,3-Bis(4-Hydroxyaryl)phthalimidine sowie dem Reaktionsprodukt von N-Phenylisatin und Phenol.

Besonders bevorzugte Diphenole sind 2,2-Bis-(4-hydroxyphenyl)-propan, 2,2-Bis-(3,5-dimethyl-4-hydroxyphenyl)-propan, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-cyclohexan und 1,1-Bis-(4-hydroxyphenyl)-3,3,5-trimethylcyclohexan.

Im Fall der Homopolycarbonate ist nur ein Diphenol eingesetzt, im Fall der Copolycarbonate sind mehrere Diphenole eingesetzt. Geeignete Kohlensäurederivate sind beispielsweise Phosgen oder Diphenylcarbonat.

Geeignete Kettenabbrecher, die bei der Herstellung der Polycarbonate eingesetzt werden können, sind sowohl Monophenole als auch Monocarbonsäuren. Geeignete Monophenole sind Phenol selbst, Alkylphenole wie Kresole, p-tert.-Butylphenol, Cumylphenol, p-n-Octylphenol, p-iso-Octylphenol, p-n-Nonylphenol und p-iso-Nonylphenol, Halogenphenole wie p-Chlorphenol, 2,4-Dichlorphenol, p-Bromphenol und 2,4,6-Tribromphenol, 2,4,6-Trijodphenol, p-Jodphenol, sowie deren Mischungen. Bevorzugte Kettenabbrecher sind Phenol, Cumylphenol und/oder p-tert.-Butylphenol.

Besonders bevorzugte Polycarbonate im Rahmen der vorliegenden Erfindung sind Homopolycarbonate auf Basis von Bisphenol A und Copolycarbonate auf Basis der Monomere ausgewählt aus mindestens einem der Gruppe aus Bisphenol A, 1,1-Bis-(4-hydroxyphenyl)- 3,3,5-trimethylcyclohexan, 2-Hydrocarbyl-3,3-Bis(4-Hydroxyaryl)phthalimidine und den Reaktionsprodukten aus N-Phenylisatin und Phenol. Die Polycarbonate können in bekannter Weise linear oder verzweigt sein. Der Anteil der Co-Monomere bezogen auf Bisphenol A beträgt im Allgemeinen bis zu 60 Gew. %, bevorzugt bis zu 50 Gew-%, besonders bevorzugt 3 bis 30 Gew-%. Mischungen von Homopolycarbonat und Copolycarbonaten können ebenfalls verwendet werden.

Polycarbonate und Co-Polycarbonate enthaltend 2-Hydrocarbyl-3,3-Bis(4-Hydroxyaryl)phthalimidine als Monomere sind unter anderem bekannt aus EP 1 582 549 A1. Polycarbonate und Co-Polycarbonate enthaltend Bisphenolmonomere basierend auf Reaktionsprodukten aus N-Phenylisatin und Phenol sind beispielsweise in WO 2008/037364 A1 beschrieben.

Die thermoplastischen, aromatischen Polycarbonate haben mittlere Molekulargewichte (Gewichtsmittel $M_w$, gemessen durch GPC (Gelpermeationschromatographie mit Polycarbonatstandard) von 10.000 bis 80.000 g/mol, bevorzugt 14.000 bis 32.000 g/mol, besonders bevorzugt 18.000 bis 32.000 g/mol. Im Falle spritzgegossener Polycarbonat-Formteile beträgt das bevorzugte mittlere Molekulargewicht 20.000 bis 29.000 g/mol. Im Falle von extrudierten Polycarbonat-Formteilen beträgt das bevorzugte mittlere Molekulargewicht 25.000 bis 32.000 g/mol.

Die Polycarbonate können ferner Füllstoffe enthalten. Als Füllstoffes sind Glaskugeln, Glashohlkugeln, Glasflakes, Ruße, Graphite, Kohlenstoffnanoröhrchen, Quarze, Talk, Glimmer, Silikate, Nitride, Wollastonit, sowie pyrogene oder gefällte Kieselsäuren, wobei die Kieselsäuren BET-Oberflächen von mindestens 50 $m^2/g$ (nach DIN 66131/2) aufweisen, geeignet.

Bevorzugte faserförmige Füllstoffe sind metallische Fasern, Kohlenstofffasern, Kunststofffasern, Glasfasern oder gemahlene Glasfasern, besonders bevorzugt sind Glasfasern oder gemahlene Glasfasern. Bevorzugte Glasfasern sind auch solche, die in der Ausführungsform Endlosfaser (rovings), Langglasfasern und Schnittglasfasern verwendet werden, die aus M-, E-, A-, S-, R- oder C-Glas herstellt werden, wobei E-, A-, oder C-Glas weiter bevorzugt sind.

Der Durchmesser der Fasern beträgt bevorzugt 5 bis 25 $\mu$m, weiter bevorzugt 6 bis 20 $\mu$m, besonders bevorzugt 7 bis 15 $\mu$m. Langglasfasern weisen bevorzugt eine Länge von 5 bis 50 mm, weiter bevorzugt von 5 bis 30 mm, noch weiter bevorzugt von 6 bis 15mm, und besonders bevorzugt von 7 bis 12 mm auf; sie werden beispielsweise in WO-A 2006/040087 beschrieben. Die Schnittglasfasern weisen bevorzugt zu mindestens 70 Gew.% der Glasfasern eine Länge von mehr als 60 $\mu$m auf.

Weitere anorganischen Füllstoffe sind anorganische Partikel mit Korngestalt ausgewählt aus der Gruppe, die sphärische / kubische, tabular / diskusförmige und plattiger Geometrien umfasst. Insbesondere geeignet sind anorganische Füllstoffe mit sphärischer oder plattiger, bevorzugt in feinteiliger und/oder poröser Form mit großer äußerer und/oder innerer Oberfläche. Dabei handelt es sich bevorzugt um thermisch inerte anorganische Materialien insbesondere basierend auf Nitride wie Bornitrid, um Oxide oder Mischoxide wie Ceroxid, Alumimiumoxid, um Carbide wie Wolframcarbid, Siliciumcarbid oder Borcarbid gepulvertem Quarz wie Quarzmehl, amorphes $SiO_2$, gemahlener Sand, Glaspartikel wie Glaspulver, insbesondere Glaskugeln, Silikate oder Alumosilikate, Graphit, insbesondere hochreiner synthetischer Graphit. Insbesondere bevorzugt sind dabei Quarz und Talk, am stärksten bevorzugt Quarz (sphärische Korngestalt). Diese Füllstoffe sind durch einen mittleren Durchmesser $d_{50\%}$ von 0,1 bis 10 $\mu$m, vorzugsweise von 0.2 bis 8.0 $\mu$m, weiter bevorzugt von 0.5 bis 5 $\mu$m, gekennzeichnet.

Silikate sind durch einen mittleren Durchmesser $d_{50\%}$ von 2 bis 10 $\mu$m, vorzugsweise von 2.5 bis 8.0 $\mu$m, weiter bevorzugt von 3 bis 5 $\mu$m, und besonders bevorzugt von 3 $\mu$m, gekennzeichnet, wobei ein oberer Durchmesser $d_{95\%}$ von entsprechend 6 bis 34 $\mu$m, weiter bevorzugt von 6.5 bis 25.0 $\mu$m, noch weiter bevorzugt von 7 bis 15 $\mu$m, und besonders bevorzugt von 10 $\mu$m bevorzugt ist. Bevorzugt weisen die Silikate eine spezifische BET-Oberfläche, bestimmt durch Stickstoffadsorption gemäß ISO 9277, von 0.4 bis 8.0 $m^2/g$, weiter bevorzugt von 2 bis 6 $m^2/g$, und besonders bevorzugt von 4.4 bis 5.0 $m^2/g$ auf.

Weiter bevorzugte Silikate weisen nur maximal 3 Gew.-% Nebenbestandteile auf, wobei vorzugsweise der Gehalt an

$Al_2O_3$ < 2.0 Gew.%,

$Fe_2O_3$ < 0.05 Gew.%,

(CaO + MgO) <0.1 Gew.%,

($Na_2O$ + $K_2O$) < 0.1 Gew.%) ist, jeweils bezogen auf das Gesamtgewicht des Silikats.

Eine weitere vorteilhafte Ausführungsform verwendet Wollastonit oder Talk in Form von feinvermahlenen Typen mit einem mittleren Partikeldurchmesser $d_{50}$ von <10 μm, bevorzugt <5 μm, besonders bevorzugt <2 μm, ganz besonders bevorzugt <1,5 μm. Die Korngrößenverteilung wird durch Windsichten bestimmt.

Die Silikate können eine Beschichtung mit silicium-organischen Verbindungen haben, wobei bevorzugt Epoxysilan-, Methylsiloxan-, und Methacrylsilan-Schlichten zum Einsatz kommen. Besonders bevorzugt ist eine Epoxysilanschlichte.

Die Füllstoffe können in einer Menge bis zu 40 Gew.% bezogen auf die Menge an Polycarbonat zugesetzt werden. Bevorzugt sind 2,0 bis 40,0 Gew.-%, bevorzugt 3,0 bis 30,0 Gew.-%, weiter bevorzugt 5,0 bis 20,0 Gew.-%, und besonders bevorzugt 7,0 bis 14,0 Gew.-%.

Als Blendpartner für Polycarbonate sind Pfropfpolymerisate von Vinylmonomeren auf Pfropfgrundlagen wie Dienkautuschke oder Acrylatkautschuke geeignet. Pfropfpolymerisate B sind bevorzugt solche aus

B.1 5 bis 95, vorzugsweise 30 bis 90 Gew.-%, wenigstens eines Vinylmonomeren auf

B.2 95 bis 5, vorzugsweise 70 bis 10 Gew.-% einer oder mehrerer Pfropfgrundlagen mit Glasübergangstemperaturen < 10°C, vorzugsweise < 0°C, besonders bevorzugt < -20°C.

Die Pfropfgrundlage B.2 hat im Allgemeinen eine mittlere Teilchengröße ($d_{50}$-Wert) von 0,05 bis 10 μm, vorzugsweise 0,1 bis 5 μm, besonders bevorzugt 0,2 bis 1 μm.

Monomere B.1 sind vorzugsweise Gemische aus

B.1.1 50 bis 99 Gew.-Teilen Vinylaromaten und/oder kernsubstituierten Vinylaromaten (wie Styrol, α-Methylstyrol, p-Methylstyrol, p-Chlorstyrol) und/oder Methacrylsäure-($C_1$-$C_8$)-Alkylester, wie Methylmethacrylat, Ethylmethacrylat), und

B.1.2 1 bis 50 Gew.-Teilen Vinylcyanide (ungesättigte Nitrile wie Acrylnitril und Methacrylnitril) und/oder (Meth)Acrylsäure-($C_1$-$C_8$)-Alkylester, wie Methylmethacrylat, n-Butylacrylat, t-Butylacrylat, und/oder Derivate (wie Anhydride und Imide) ungesättigter Carbonsäuren, beispielsweise Maleinsäureanhydrid und N-Phenyl-Maleinimid.

Bevorzugte Monomere B.1.1 sind ausgewählt aus mindestens einem der Monomere Styrol, α-Methylstyrol und Methylmethacrylat, bevorzugte Monomere B.1.2 sind ausgewählt aus mindestens einem der Monomere Acrylnitril, Maleinsäureanhydrid und Methylmethacrylat. Besonders bevorzugte Monomere sind B.1.1 Styrol und B.1.2 Acrylnitril.

Für die Pfropfpolymerisate B geeignete Pfropfgrundlagen B.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke.

Bevorzugte Pfropfgrundlagen B.2 sind Dienkautschuke, beispielsweise auf Basis Butadien und Isopren, oder Gemische von Dienkautschuken oder Copolymerisate von Dienkautschuken oder deren Gemischen mit weiteren copolymerisierbaren Monomeren (z.B. gemäß B.1.1 und B.1.2), mit der Maßgabe, dass die Glasübergangstemperatur der Komponente B.2 unterhalb < 10°C, vorzugsweise < 0°C, besonders bevorzugt < -10°C liegt. Besonders bevorzugt ist reiner Polybutadienkautschuk.

Besonders bevorzugte Polymerisate B sind beispielsweise ABS-Polymerisate (Emulsions-, Masse- und Suspensions-ABS), wie sie z.B. in der DE-OS 2 035 390 (=US-PS 3 644 574) oder in der DE-OS 2 248 242 (=GB-PS 1 409 275) bzw. in Ullmanns, Enzyklopädie der Technischen Chemie, Bd. 19 (1980), S. 280 ff. beschrieben sind. Der Gelanteil der Pfropfgrundlage B.2 beträgt mindestens 30 Gew.-%, vorzugsweise mindestens 40 Gew.-% (in Toluol gemessen).

Die Pfropfcopolymerisate B werden durch radikalische Polymerisation, z.B. durch Emulsions-, Suspensions-, Lösungs- oder Massepolymerisation, vorzugsweise durch Emulsions- oder Massepolymerisation hergestellt.

Da bei der Pfropfreaktion die Pfropfmonomeren bekanntlich nicht unbedingt vollständig auf die Pfropfgrundlage

aufgepfropft werden, werden erfindungsgemäß unter Pfropfpolymerisaten B auch solche Produkte verstanden, die durch (Co)Polymerisation der Pfropfmonomere in Gegenwart der Pfropfgrundlage gewonnen werden und bei der Aufarbeitung mit anfallen.

Die Polymer-Zusammensetzungen können optional noch weitere übliche Polymeradditive enthalten, wie z.B. die in EP-A 0 839 623, WO-A 96/15102, EP-A 0 500 496 oder "Plastics Additives Handbook", Hans Zweifel, 5th Edition 2000, Hanser Verlag, München) beschriebenen Antioxidantien, Thermostabilisatoren, Entformungsmittel, optischen Aufheller, UV Absorber und Lichtstreumittel in den für die jeweiligen Thermoplasten üblichen Mengen.

Als UV-Stabilisatoren sind Benzotriazole, Triazine, Benzophenone und/oder arylierte Cyanoacrylate geeignet. Besonders geeignete UV-Absorber sind Hydroxy-Benzotriazole, wie 2-(3',5'-Bis-(1,1-dimethylbenzyl)-2'-hydroxy-phenyl)-benzotriazol (Tinuvin® 234, Ciba Spezialitätenchemie, Basel), 2-(2'-Hydroxy-5'-(tert.-octyl)-phenyl)-benzotriazol (Tinuvin® 329, Ciba Spezialitätenchemie, Basel), 2-(2'-Hydroxy-3'-(2-butyl)-5'-(tert.butyl)-phenyl)-benzotriazol (Tinuvin® 350, Ciba Spezialitätenchemie, Basel), Bis-(3-(2H-benztriazolyl)-2-hydroxy-5-tert.-octyl)methan, (Tinuvin® 360, Ciba Spezialitätenchemie, Basel), (2-(4,6-Diphenyl-1,3,5-triazin-2-yl)-5-(hexyloxy)-phenol (Tinuvin® 1577, Ciba Spezialitätenchemie, Basel), sowie der Benzophenone 2,4-Dihydroxy-benzophenon (Chimasorb® 22, Ciba Spezialitätenchemie, Basel) und 2-Hydroxy-4-(octyloxy)-benzophenon (Chimassorb® 81, Ciba, Basel), 2-Propenoic acid, 2-Cyano-3,3-diphenyl-, 2,2-Bis[[(2-cyano-1-oxo-3,3-diphenyl-2-propenyl)oxy]-methyl]-1,3-propanediylester (9CI) (Uvinul® 3030, BASF AG Ludwigshafen), 2-[2-Hydroxy-4-(2-ethylhexyl)oxy]phenyl-4,6-di(4-phenyl)phenyl-1,3,5-triazine (CGX UVA 006, Ciba Spezialitätenchemie, Basel) oder Tetra-ethyl-2,2'-(1,4-phenylene-dimethylidene)-bismalonate (Hostavin® B-Cap, Clariant AG).

Die Polymer-Zusammensetzung kann UV-Absorber üblicherweise in einer Menge von 0 bis 5 Gew.%, bevorzugt 0,1 bis 2,5 Gew.% bezogen auf die Gesamtzusammensetzung enthalten.

Die Herstellung der Polymer-Zusammensetzungen erfolgt mit gängigen Einarbeitungsverfahren durch Zusammenführung, Vermischen und Homogenisieren der einzelnen Bestandteile, wobei insbesondere die Homogenisierung bevorzugt in der Schmelze unter Einwirkung von Scherkräften stattfindet. Gegebenenfalls erfolgt das Zusammenführen und Vermischen vor der Schmelzehomogenisierung unter Verwendung von Pulvervormischungen.

Das Substratmaterial kann als Folie oder Platte vorliegen. Die Folie kann verformt und mit einem weiteren Thermoplasten aus den oben genannten Thermoplasten hinterspritzt werden (Film Insert Molding (FIM)). Platten können thermogeformt oder mittels Drape-Forming bearbeitet bzw. kalt eingebogen werden. Auch ist eine Formgebung über Spritzguss-Prozesse möglich. Diese Prozesse sind dem Fachmann bekannt.

Die Dicke der Substratschicht muss hierbei so beschaffen sein, dass im Bauteil eine hinreichende Steifigkeit gewährleistet ist.

Im Falle einer Folie kann die Substratschicht A durch Hinterspritzen verstärkt werden, um eine ausreichende Steifigkeit zu gewährleisten.

Die Gesamtdicke der Schicht A, d.h. einschließlich einer möglichen Hinterspritzung, beträgt im allgemeinen 1μm - 10 mm. Besonders bevorzugt beträgt die Dicke der Schicht A) 1 mm - 10 mm, 1 mm - 5 mm, 2 mm - 4 mm. Insbesondere beziehen sich die Dickenangaben auf die Gesamtsubstratdicke bei Verwendung von Polycarbonat als Substratmaterial einschließlich einer möglichen Hinterspritzung.

Bei PET beträgt die Schichtdicke vorzugsweise 10μm - 100 μm (PET), die Dicker einer PC-Folie beträgt bevorzugt 100 μm - 1mm (PC-Folie), wobei durch Hinterspritzung diese Thermoplasten verstärkt werden können.

Bei metallischen Substraten beträgt die Schichtdicke im Allgemeinen 300 μm - 750 μm. Bei Glassubstraten beträgt die Schichtdicke im Allgemeinen 750 μm - 3 mm, bevorzugt 800 μm - 2 mm.

**Schicht B:**

Schicht B ist ausgewählt aus den oben genannten Metallen. Schicht B ist bevorzugt frei von Kupfer oder Kupfer haltigen Verbindungen bzw. Kupfer haltigen Legierungen.

Die Dicke der Schicht B beträgt im allgemeinen 40 nm - 250 nm, bevorzugt 55 nm - 200 nm und insbesondere 80 nm - 130 nm.

Die besonders bevorzugte Schichtdicke bei Verwendung von Titan liegt im Bereich von 105 nm - 120 nm.

**Schicht C:**

Die Dicke der Schicht C beträgt im allgemeinen 80 nm - 250 nm, bevorzugt 90 nm - 160 nm und besonders bevorzugt 100 nm - 130 nm.

Im Falle von Silber wird hochreines Silber eingesetzt. Kommerziell verfügbare Produkte sind bei Heraeus Precious Metals (z.B: Target Ag Reinheit 3N7) oder Umicore erhältlich.

**Schicht D:**

Die Dicke der Schicht D beträgt im allgemeinen 80 nm - 250 nm, bevorzugt 90 nm - 160 nm, besonders bevorzugt 90 nm - 130 nm und ganz besonders bevorzugt 90 nm - 110 nm.

**Schicht E:**

Die Dicke der Schicht E beträgt im allgemeinen 1 nm - 200 nm, bevorzugt 10 nm - 150 nm, besonders bevorzugt 20 nm- 100 nm und ganz besonders bevorzugt 30 nm - 50 nm.

**Aufbringen der Schichten:**

Die Schichten B und C werden jeweils durch Aufdampfen oder durch Sputtern aufgebracht.

Die Schicht D wird reaktiv aufgedampft oder reaktiv gesputtert mit Sauerstoff als Reaktivgas. Diese Verfahren sind allgemein bekannt und zum Beispiel beschrieben in Vakuumbeschichtung, Band 1-5, Hrsg. Hartmut Frey, VDI Verlag, 1995.

Der Auftrag von Metallen auf das Polymer kann über verschiedene Methoden wie z.B. durch Aufdampfen oder Sputtern geschehen. Die Verfahren sind näher beschrieben z.B. in "Vakuumbeschichtung Bd.1 bis 5", H. Frey, VDI-Verlag Düsseldorf 1995 oder "Oberflächen- und Dünnschicht-Technologie" Teil 1, R.A. Haefer, Springer Verlag 1987.

Um eine bessere Metallhaftung zu erreichen und um die Substratoberfläche zu reinigen, werden die Substrate normalerweise einer Plasmavorbehandlung unterzogen. Eine Plasmavorbehandlung kann u. U. die Oberflächeneigenschaften von Polymeren verändern. Diese Methoden sind z.B. bei Friedrich et al. in Metallized plastics 5 & 6: Fundamental and applied aspects und H. Grünwald et al. in Surface and Coatings Technology 111 (1999) 287-296 beschrieben.

Die Schicht E wird in einem PECVD (plasma enhanced chemical vapour deposition) oder Plasmapolymerisationsprozess aufgebracht. Hierbei werden niedrigsiedende Precursoren haupsächlich auf Siloxan-Basis in ein Plasma verdampft und dadurch aktiviert, so dass sie einen Film bilden können. Das Verfahren ist unter anderem beschrieben in Surface and Coatings Technology 111 (1999), 287-296.

**Schicht F:**

Anorganische Deckschichten im Sinne der vorliegenden Erfindung sind Lacke, die nach dem Sol-Gel-Prozess hergestellt werden und unten beschrieben sind. Der Sol-Gel-Prozess ist ein Verfahren zur Synthese nichtmetallischer anorganischer oder hybridpolymerer Materialien aus kolloidalen Dispersionen, den sogenannten Solen.

Anorganische Deckschichten, die nach dem Sol-Gel Prozess hergestellt wurden, sind kommerziell unter der Bezeichnung Silfort PHC587, Silfort PHC587B, Silfort PHC587C, Silfort SHC5020, Silfort AS4000 sowie Silfort AS4700 (Momentive Performance Materials), CrystalCoat 6000 (SDC Technologies), PERMA-NEW 6000 (oder PERMA-NEW 6000B) CLEAR HARD COATING SOLUTION (California Hardcoating Co.) sowie KASI flex und KASI sunflex (KRD) verfügbar.

Die Deckschicht ist dadurch gekennzeichnet, dass sie keine UV Absorber enthält.

Die Sol-Gel-Beschichtungslösungen werden durch Hydrolyse wässriger Dispersionen von kolloidem Siliziumdioxid und einem Organoalkoxysilan und/oder einem Alkoxysilan oder Mischungen aus Organoalkoxysilanen der allgemeinen Formel RSi(OR')3 und/oder Alkoxysilanen der allgemeinen Formeln Si(OR')4 herstellt werden, wobei in den Organoalkoxysilan(en) der allgemeinen Formel RSi(OR')3 R für einen monovalenten C1 bis C6 - Alkyl-Rest oder für einen ganz oder teilweise fluorierten C1 - C6 - Alkylrest, für eine Vinyl- oder eine Allyl-Einheit, einen Arylrest oder für ein C1 - C6 Alkoxygruppe steht. Besonders bevorzugt ist R eine C1 bis C4-Alkylgruppe, eine Methyl-, Ethyl-, n-Propyl-, iso-Propyl-, tert.-Butyl-, sek.-Butyl- oder n-Butylgruppe, eine Vinyl-, Allyl-, Phenyl- oder substituierte Phenyleinheit. Die - OR' sind unabhängig voneinander ausgewählt aus der Gruppe enthaltend C1 bis C6 - Alkoxygruppen, eine Hydroxygruppe, eine Formyleinheit und eine Acetyl-Einheit. Sol-Gel-Polysiloxanlacke fallen teilweise auch unter die Definition eines Hybridlackes.

Das kolloide Siliziumdioxid ist beispielsweise als z.B. Levasil 200 A (HC Starck), Nalco 1034A (Nalco Chemical Co), Ludox AS-40 oder Ludox LS (GRACE Davison) erhältlich. Als Organoalkoxysilane seien beispielhaft folgende Verbindungen genannt: 3,3,3-Trifluoropropytrimethoxysilan, Methyltrimethoxysilan, Methyltrihydroxysilan, Methyltriethoxysilan, Ethyltrimethoxysilan, Methyltriacetoxysilan, Ethyltriethoxysilan, Phenyltrialkoxysilan (z.B. Phenyltriethoxysilan und Phenyltrimethoxysilan) und Mischungen daraus. Als Alkoxysilane seien beispielhaft folgende Verbindungen genannt: Tetramethoxysilan und Teraethoxysilan und Mischungen daraus.

Als Katalysatoren können beispielsweise organische und/oder anorganische Säuren oder Basen verwendet werden.

In einer Ausführungsform können die kolloiden Siliziumdioxidpartikel auch durch Vorkondensation ausgehend

von Alkoxysilanen in situ gebildet werden (siehe hierzu "The Chemistry of Silica", Ralph K. Iler, John Wiley & Sons, (1979), p. 312-461).

Die Hydrolyse der Sol-Gel-Lösung wird durch Zugabe von Lösungsmitteln, bevorzugt alkoholischen Lösungsmitteln wie z.B. Isopropanol, n-Butanol, Isobutanol oder Mischungen daraus, abgebrochen bzw. stark verlangsamt. Anschließend folgt ein Alterungsschritt von wenigen Stunden oder mehreren Tagen/Wochen. Des Weiteren können Additive und/oder Stabilisatoren wie beispielsweise Verlaufsmittel, Oberflächenadditive, Verdickungsmittel, Pigmente, Farbstoffe, Härtungskatalysatoren, IR-Absorber, UV-Absorber und/oder Haftvermittler zugesetzt werden. Auch die Verwendung von Hexamethyldisilazan oder vergleichbaren Verbindungen, die zu einer reduzierten Rissanfälligkeit der Beschichtungen führen können, ist möglich (vgl. auch WO 2008/109072 A).

Hybridlacke im Sinne der vorliegenden Erfindung basieren auf der Verwendung von Hybridpolymeren als Bindemittel. Hybridpolymere (Hybride: lat. "von zweierlei Herkunft") sind polymer basierte Werkstoffe, die Struktureinheiten verschiedener Materialklassen auf molekularer Ebene in sich vereinen. Durch ihren Aufbau können Hybridpolymere völlig neuartige Eigenschaftskombinationen aufweisen. Im Unterschied zu Verbundwerkstoffen (definierte Phasengrenzen, schwache Wechselwirkungen zwischen den Phasen) und Nanokompositen (Verwendung nanoskaliger Füllstoffe) sind die Struktureinheiten von Hybridpolymeren auf molekularer Ebene miteinander verknüpft. Dies gelingt durch chemische Verfahren wie z. B. den Sol-Gel-Prozess, mit dem anorganische Netzwerke aufgebaut werden können. Durch den Einsatz von organisch reaktiven Precursoren z. B. organisch modifizierten Metall-Alkoxiden können zusätzlich organische Oligomer/Polymerstrukturen erzeugt werden. Oberflächenmodifizierte Nanopartikel enthaltende Acrylatlacke, die nach der Härtung ein organisch/anorganisches Netzwerk bilden, werden ebenfalls als Hybridlack definiert. Es gibt thermisch härtbare und UV-härtbare Hybridlacke.

Als Schicht F werden thermisch-härtbare Sol-Gel-Lacke ohne zusätzlichen UV-Absorber, wie beispielsweise von der Fa. Momentive Performance Materials unter der Produktbezeichnung SHC5020 erhältlich, eingesetzt. Sol-Gel-Polysiloxanlacke werden in Schichtdicken von 1 bis 20 μm, bevorzugt 2 bis 15 μm, besonders bevorzugt 4 bis 12 μm eingesetzt.

Für den Fall, dass in dem erfindungsmäßen Schichtaufbau die Schicht D Aluminiumoxid enthält, wird die Deckschicht F bevorzugt durch ein anorganisches Lacksystem gebildet.

Optional kann ein Primer zwischen der anorganischen Deckschicht F und der Schicht E Verwendung finden. Der Primer hat die Aufgabe die Haftvermittlung zwischen diesen beiden Schichtsystemen zu gewährleisten. Bevorzugte Primer basieren auf Poly(meth)acrylaten, bevorzugt Polymethylmethacrylat (PMMA), und sind kommerziell erhältlich unter der Produktbezeichnung SHP401, SHP470 oder SHP470FT von der Fa. Momentive Performance Materials. Üblicherweise werden diese in Schichtdicken zwischen 50nm und 4μm, bevorzugt zwischen 100nm und 1,3μm (SHP401) sowie 1,2μm bis 4μm (SHP470 bzw. SHP470FT) verwendet.

Die Applikation der anorganischen Deckschichten sowie Primer erfolgt bevorzugt durch Fluten, Gießen, Rakeln, Sprühen, Walzen oder Tauchen, insbesondere durch Fluten, Gießen oder Sprühen.

Bevorzugt liegen die Härtungstemperaturen der anorganischen Deckschicht bei kleiner gleich 100°C falls in dem Gesamtaufbau der vorliegenden Erfindung die Schicht D verwendet wird.

In einer alternativen Ausführungsform der vorliegenden Erfindung ist die Schicht D frei von Aluminiumoxid und die Härtung der Schicht F erfolgt bei Temperaturen größer 100°C.

In einer weiteren bevorzugten Ausführungsform werden die anorganischen Deckschichten der Schicht F durch chemische Gasphasenabscheidung, einem PECVD (plasma enhanced chemical vapour deposition) oder Plasmapolymerisationsprozess aufgebracht. Hierbei werden niedrigsiedende Precursoren haupsächlich auf Siloxan-Basis in ein Plasma verdampft und dadurch aktiviert, so dass sie einen Film bilden können.

Als Precursoren werden beispielsweise und bevorzugt Hexamethyldisiloxan (HMDSO), Octamethylcyclotetrasiloxan (OMCTS), Octamethyltrissiloxan (OMTS), Tetraethylorthosilan (TEOS), und Tetrametyldisiloxan (TMDSO), Decamethylcyclopentasiloxan (DMDMS), Hexamethylcyclotrisiloxan (HMCTS), Trimethoxymethylsilan (TMOMS), Tetramethylcyclotetrasiloxan (TMCTS); besonders bevorzugt wird HMDSO eingesetzt.

Bevorzugte Schichtdicken sind größer gleich 1μm. Mit Hilfe des Sauerstoffs zum Precursorverhältnis kann die mechanische Stabilität der resultierenden Schichten variiert werden. Das bevorzugte Verhältnis hängt vom verwendeten Precursor ab. Für HMDSO liegt das bevorzugte Verhältnis von Sauerstoff zu HMDSO bei 50 bis 1, besonders bevorzugt bei 30 bis 1 und insbesondere bevorzugt bei 20 bis 5.

Das Verfahren ist unter anderem beschrieben in Surface and Coatings Technology 111 (1999), 287-296.

**Beispiele:**

**Herstellung der Platte:**

Es wurden Spritzguss-Rechteckplatten mit den Maßen 150 x 105 x 3,2 mm mit Seitenanguss angefertigt. Die Massetemperatur betrug 300 - 330°C und die Werkzeugtemperatur 100°C. Das jeweilige Granulat wurde vor Verarbeitung für 5 Stunden im Vakuumtrockenschrank bei 120°C getrocknet.

PC-1: Makrolon® 2407, Bayer MaterialScience AG, Leverkusen, Deutschland, mit einer Schmelze-Volumenfließrate (MVR) von 19 $cm^3$/10min, gemessen nach ISO 1133 bei 300 und 1,2 kg.
PC-2: Makrolon® GP U099, Bayer MaterialScience AG, Leverkusen, Deutschland, mit einer Schmelze-Volumenfließrate (MVR) von 10 $cm^3$/10min, gemessen nach ISO 1133 bei 300 und 1,2 kg.

**Beispiel 1: Mehrschichtaufbau - erfindungsgemäß**

Die PC-Platte (PC-1) wurde beschichtet gemäß nachfolgender Beschreibung. Folgender Schichtaufbau wurde realisiert:

3,2 mm Substrat\\110nm Ti\\120nm Ag\\100nm AlOx\\40nm HMDSO

Herstellungsverfahren:

1. Die PC-Platte wurde in die Vakuumkammer eingeschleust und bis auf $p< 2\cdot 10^{-5}$ mbar evakuiert.
2. Plasmavorbehandlung: Die PC-Platte wurde 1 min bei 500W und 0,1 mbar Ar im Mittelfrequenz-Plasma (40kHz) vorbehandelt.
3. Schicht B: Die Titan-Schicht wurde mittels DC sputtern abgeschieden. Als Beschichtungsquelle wurde ein rundes Planarmagnetron ION'X-8"HV von Thin Film Consulting mit einem Durchmesser von 200mm verwendet, die mit einem Generator "Pinnacle™ Plus+ 5kW" von Advanced Energy betrieben wurde. Zuerst wurde das Target (hier: Titan) bei geschlossener Blende für 1min freigesputtert und dann bei offener Blende innerhalb von 3min 40s mit 2000W und einem Druck von $p= 5\cdot 10^{-3}$ mbar die Titanschicht auf der PC-Platte abgeschieden.
4. Schicht C: Die Silber-Schicht wurde mittels DC sputtern abgeschieden. Als Beschichtungsquelle wurde ein rundes Planarmagnetron ION'X-8"HV von Thin Film Consulting mit einem Durchmesser von 200mm verwendet, die mit einem Generator "Pinnacle™ Plus+ 5kW" von Advanced Energy betrieben wurde. Zuerst wurde das Target (hier: Silber) bei geschlossener Blende für 1min freigesputtert und dann bei offener Blende innerhalb von 51s mit 2000W und einem Druck von $p= 5\cdot 10^{-3}$ mbar die Silberschicht auf der Titanschicht abgeschieden.

Danach wurde die beschichtete PC-Platte aus der Beschichtungsanlage entnommen und die Beschichtungsanlage für die letzten Schichten vorbereitet.

5. Die beschichtete PC-Platte wurde wieder in die Vakuumkammer eingeschleust und bis auf $p< 2\cdot 10^{-5}$ mbar evakuiert.
6. Plasmavorbehandlung: die beschichtete PC-Platte wurde 1 min bei 500W und 0,1 mbar Ar im Mittelfrequenz-Plasma (40kHz) vorbehandelt.
7. Schicht D: Die $AlO_x$-Schicht wurde mittels reaktiv, gepulstem DC sputtern mit einer Pulsfrequenz von 150 kHz abgeschieden. Als Beschichtungsquelle wurde ein rundes Planarmagnetron ION'X-8"HV von Thin Film Consulting mit einem Durchmesser von 200mm verwendet, die mit einem Generator Advanced Energy "Pinnacle™ Plus+ 5kW" betrieben wurde. Zuerst wurde das Target (hier: Aluminium) bei geschlossener Blende für 1min freigesputtert und dann bei offener Blende innerhalb von 4min bei 340V im spannungsgeregeltem Mode und einem Gesamtdruck von $p= 5\cdot 10^{-3}$ mbar die $AlO_x$-Schicht auf der Silberschicht abgeschieden. Das $O_2$/Ar-Verhältnis wurde auf 8% eingestellt.
8. Schicht E: Mittels Plasmapolymerisation wurde HMDSO (Hexamethyldisiloxan) auf die AlOx-Schicht als weitere Schutzschicht aufgebracht. Die Schicht wurde bei einem Anfangsdruck von p=0.038 mbar und Fluss von 90sscm HMDSO und 1500W Mittelfrequenzleistung (40kHz) während 35s aufgebracht. Als Quelle wurde eine Parallelreaktoreinheit verwendet mit einem Plattenabstand von ca. 200mm, wobei sich die Platte in der Mitte befand. Die Quelle wurde mit einem Advanced Energy PEII (5kW) inkl. Hochspannungstrafo LMII betrieben.

Die Platte wurde während allen Beschichtungsschritten über die Beschichtungsquellen mit ca. 20rpm rotiert, um die Homogenität der Beschichtung zu erhöhen.

**Beispiel 2: Mehrschichtaufbau - erfindungsgemäß**

Die PC-Platte (PC-1) wurde beschichtet gemäß nachfolgender Beschreibung. Folgender Schichtaufbau wurde realisiert:

3,2 mm Substrat\\110nm Ti\\120nm Ag\\40nm HMDSO

Herstellungsverfahren:

1. Die PC-Platte wurde in die Vakuumkammer eingeschleust und bis auf p< $2 \cdot 10^{-5}$ mbar evakuiert.
2. Plasmavorbehandlung: Die PC-Platte wurde 1 min bei 500W und 0,1 mbar Ar im Mittelfrequenz-Plasma (40kHz) vorbehandelt.
3. Schicht B: Die Titan-Schicht wurde mittels DC sputtern abgeschieden. Als Beschichtungsquelle wurde ein rundes Planarmagnetron ION'X-8"HV von Thin Film Consulting mit einem Durchmesser von 200mm verwendet, die mit einem Generator "Pinnacle™ Plus+ 5kW" von Advanced Energy betrieben wurde. Zuerst wurde das Target (hier: Titan) bei geschlossener Blende für 1min freigesputtert und dann bei offener Blende innerhalb von 3min 40s mit 2000W und einem Druck von p= $5 \cdot 10^{-3}$ mbar die Titanschicht auf der PC-Platte abgeschieden.
4. Schicht C: Die Silber-Schicht wurde mittels DC sputtern abgeschieden. Als Beschichtungsquelle wurde ein rundes Planarmagnetron ION'X-8"HV von Thin Film Consulting mit einem Durchmesser von 200mm verwendet, die mit einem Generator "Pinnacle™ Plus+ 5kW" von Advanced Energy betrieben wurde. Zuerst wurde das Target (hier: Silber) bei geschlossener Blende für 1min freigesputtert und dann bei offener Blende innerhalb von 51s mit 2000W und einem Druck von p= $5 \cdot 10^{-3}$ mbar die Silberschicht auf der Titanschicht abgeschieden.

Danach wurde die beschichtete PC-Platte aus der Beschichtungsanlage entnommen und die Beschichtungsanlage für die letzten Schichten vorbereitet.

5. Die beschichtete PC-Platte wurde wieder in die Vakuumkammer eingeschleust und bis auf p< $2 \cdot 10^{-5}$ mbar evakuiert.
6. Plasmavorbehandlung: die beschichtete PC-Platte wurde 1 min bei 500W und 0,1 mbar Ar im Mittelfrequenz-Plasma (40kHz) vorbehandelt.
7. Schicht E: Mittels Plasmapolymerisation wurde HMDSO (Hexamethyldisiloxan) auf die Silber-Schicht als weitere Schicht aufgebracht. Die Schicht wurde bei einem Anfangsdruck von p=0.038 mbar und Fluss von 90sscm HMDSO und 1500W Mittelfrequenzleistung (40kHz) während 35s aufgebracht. Als Quelle wurde eine Parallelreaktoreinheit verwendet mit einem Plattenabstand von ca. 200mm, wobei sich die Platte in der Mitte befand. Die Quelle wurde mit einem Advanced Energy PEII (5kW) inkl. Hochspannungstrafo LMII betrieben.
8. Plasmavorbehandlung: die beschichtete PC-Platte wurde 1 min bei 500W und 0,1 mbar $O_2$ im Mittelfrequenz-Plasma (40kHz) vorbehandelt.

Die Platte wurde während allen Beschichtungsschritten über die Beschichtungsquellen mit ca. 20rpm rotiert, um die Homogenität der Beschichtung zu erhöhen.

**Einstellung der Schichtdicken:**

Zur Einstellung der Schichtdicken erfolgte zunächst eine Kalibrierung der Prozessparameter. Hierzu wurden unterschiedliche Schichtdicken bei definierten Prozessparametern auf einen Objektträger abgeschieden, der zur Erzeugung einer Stufe in der Mitte mit einem Klebestreifen versehen wurde. Nach Abscheidung der jeweiligen Schicht wurde der Klebestreifen entfernt und die Höhe der entstandenen Stufe mit einem Stufenabtaster KLA Tencor Alpha-Step 500 Surface Profiler von Tencor Instruments bestimmt.
Hierdurch werden Prozessparameter ermittelt, die für die Herstellung der gewünschten Zielschichtdicke eingestellt werden müssen.

**Messung der Schichtdicke am Fertigteil:**

Am Fertigteil lässt sich die Schichtdicke mittels TOF-SIMS (Time of Flight - Secondary Ion Mass Spectrometry) oder mit XPS (X-ray Photospectroscopy) in Kombination mit TEM (Transmission Electron Microscopy) bestimmen.

**Applikationen der Deckschichten (Schichten F):**

In den nachfolgenden Beispielen wurden nachfolgende kommerziell verfügbare Deckschichtsysteme der Firma Momentive Performance Materials verwendet.

- SHP401: PMMA-Lösung in organischen Lösungsmitteln
- AS4000: thermisch-härtbarer anorganischer Decklack enthaltend UV-Absorber

- SHC5020: thermisch-härtbarer anorganischer Decklack ohne UV-Absorber
- UVHC3000: strahlungs-härtbarer organischer Decklack enthaltend UV-Absorber
- UVHC7800: strahlungs-härtbarer organischer Decklack ohne UV-Absorber

**Beispiel 3a) Applikation von SHP401/SHC5020 auf die Schichtfolge aus Beispiel 2 bei hoher Einbrenntemperatur (erfindungsgemäß)**

Die Applikation des Primers SHP401 auf die Schicht E der Schichtfolge aus Beispiel 1 erfolgte bei 21°C und 34% relativer Feuchte durch Fluten. Während einer nachfolgenden Ablüftzeit von 30 Minuten bei zuvor genanntem Klima konnten restliche in der Lackschicht enthaltene Lösungsmittel verdunsten.

Anschließend erfolgte die Applikation des Beschichtungsmittels SHC5020 auf die Primer-Schicht ebenfalls bei 21°C und 34% relativer Feuchte durch Fluten. Während einer nachfolgenden Ablüftzeit von 30 Minuten bei zuvor genanntem Klima konnten restliche in der Lackschicht enthaltene Lösungsmittel verdunsten. Abschließend wurde das Schichtsystem bestehend aus SHP401 und SHC5020 bei 130°C für 30 Minuten im Umluft-Trockenschrank gehärtet.

**Beispiel 3b) Applikation von SHC5020 auf die Schichtfolge aus Beispiel 2 bei hoher Einbrenntemperatur (erfindungsgemäß)**

Die Applikation des Beschichtungsmittels SHC5020 auf die Schicht E der Schichtfolge aus Beispiel 2 erfolgte bei 21°C und 34% relativer Feuchte durch Fluten. Während einer nachfolgenden Ablüftzeit von 30 Minuten bei zuvor genanntem Klima konnten restliche in der Lackschicht enthaltene Lösungsmittel verdunsten.

Abschließend wurde das Schichtsystem bestehend aus SHC5020 bei 130°C für 30 Minuten im Umluft-Trockenschrank gehärtet.

Es erfolgte die visuelle Überprüfung der Schichtfolgen aus den Beispielen 3a und 3b nach deren Herstellung.

| Beispiel | Ergebnis der visuellen Überprüfung |
|---|---|
| 3a | keine Auffälligkeiten; die Oberfläche ist intakt |
| 3b | keine Auffälligkeiten; die Oberfläche ist intakt |

Bewitterungsergebnisse:

Test- und Auswertemethoden:

| Prüfung | Bedingungen | Zeit (h) | Beurteilung |
|---|---|---|---|
| Klimawechsel-Test (DIN EN 62108 10.6 & 10.8) | 100 Zyklen von -40°C bis 110°C (14 Zyklen pro Tag) gefolgt von 20 Zyklen Feuchte-Frost-Test (20h bei 85°C/85% relative Feuchte gefolgt von 4h Abkühlung auf -40°C und danach wieder aufheizen auf 85°C/85% relative Feuchte) | Ca. 650h | Bestimmung von RI |
| Xenon-Test | 0,75W/m$^2$/nm bei 340nm, Boro-Boro Filter, Schwarztafeltemperatur 70°C, 50% relative Feuchte, ohne Beregnung | 500h | Bestimmung von RI |
| Damp Heat Test (DIN EN 62108 10.7) | 85°C, 85% relative Feuchte | 2000h | Bestimmung von RI |
| Dry Heat Test | Im Umlufttrockenschrank bei 125°C | 1000h | Bestimmung von RI |

Bestimmung von RI (Reflexions-Index):

1. Bestimmung von totalem ($R_{total}$) und diffusem ($R_{diffus}$) Reflexionsgrad mittels Photospektrometer Perkin Elmer Lambda 900, kalibriert auf Spektralon-Standard im Bereich von $\lambda$= 200-1100nm
2. Berechnung der direkten Reflexion: $R_{direkt} = R_{total} - R_{diffus}$
3. Berechnung von $RI_i = \frac{1}{Norm}\sum_i R_{direct}(\lambda) \cdot EQE_i(\lambda) \cdot SP(\lambda)$ mit *i=1,2,3* mit *i=1,2,3*

4. Wobei *RI = min ($RI_i$)* mit *i = 1,2*.

$EQE_i(\lambda)$ (External Quantum Efficiency): z.B. Spectrolab C1MJ
$SP(\lambda)$ : Sonnenspektrum nach ASTM G173-03

Direkter Reflexionsgrad und RI - Ausgangswerte:

| Rdirekt | RI | 400nm | 500nm | 700nm | 900nm |
|---|---|---|---|---|---|
| Bsp. 3a | 96,05 | 89,29 | 96,19 | 97,99 | 98,26 |
| Bsp. 3b | 95,90 | 89,53 | 95,95 | 97,73 | 97,76 |

RI nach der Bewitterung:

| RI | Klimawechsel Test 100TC + 20HF | Xenon Test (nach 500h) | Damp Heat Test 2000h | Dry Hot Test 1000h |
|---|---|---|---|---|
| Bsp. 3a | 95,00 | 93,63 | 94,38 | 95,21 |
| Bsp. 3b | 94,90 | 90,87 | 94,95 | 96,45 |

Aus den vorliegenden Ergebnissen der Versuchsreihe 3 geht hervor, dass die Reflektivität der Schichtsysteme nach den durchgeführten Alterungstests nicht wesentlich beeinflusst wird. Durch die Schicht F wird der Schichtaufbau enthaltend Schicht A bis E ausreichend geschützt.

**Beispiel 4a) Applikation von SHP401/AS4000 auf die Schichtfolge aus Beispiel 1 bei hoher Einbrenntemperatur (Vergleich)**

Die Applikation des Primers SHP401 auf die Schicht E der Schichtfolge aus Beispiel 1 erfolgte bei 21°C und 32% relativer Feuchte durch Fluten. Während einer nachfolgenden Ablüftzeit von 30 Minuten bei zuvor genanntem Klima konnten restliche in der Lackschicht enthaltene Lösungsmittel verdunsten.

Anschließend erfolgte die Applikation des Beschichtungsmittels AS4000 auf die Primer-Schicht ebenfalls bei 21°C und 32% relativer Feuchte durch Fluten. Während einer nachfolgenden Ablüftzeit von 30 Minuten bei zuvor genanntem Klima konnten restliche in der Lackschicht enthaltene Lösungsmittel verdunsten. Abschließend wurde das Schichtsystem bestehend aus SHP401 und AS4000 bei 130°C für 60 Minuten im Umluft-Trockenschrank gehärtet.

**Beispiel 4b) Applikation von SHP401/AS4000 auf die Schichtfolge aus Beispiel 1 bei niedriger Einbrenntemperatur (Vergleich)**

Die Applikation des Primers SHP401 auf die Schicht E der Schichtfolge aus Beispiel 1 erfolgte bei 22°C und 32% relativer Feuchte durch Fluten. Während einer nachfolgenden Ablüftzeit von 30 Minuten bei zuvor genanntem Klima konnten restliche in der Lackschicht enthaltene Lösungsmittel verdunsten.

Anschließend erfolgte die Applikation des Beschichtungsmittels AS4000 auf die Primer-Schicht ebenfalls bei 22°C und 32% relativer Feuchte durch Fluten. Während einer nachfolgenden Ablüftzeit von 30 Minuten bei zuvor genanntem Klima konnten restliche in der Lackschicht enthaltene Lösungsmittel verdunsten. Abschließend wurde das Schichtsystem bestehend aus SHP401 und AS4000 bei 100°C für 120 Minuten im Umluft-Trockenschrank gehärtet.

**Beispiel 4c) Applikation von SHC5020 auf die Schichtfolge aus Beispiel 1 bei niedriger Einbrenntemperatur (erfindungsgemäß)**

Die Applikation des Beschichtungsmittels SHC5020 auf die Schicht E der Schichtfolge aus Beispiel 1 erfolgte bei 22°C und 32% relativer Feuchte durch Fluten. Während einer nachfolgenden Ablüftzeit von 30 Minuten bei zuvor genanntem Klima konnten restliche in der Lackschicht enthaltene Lösungsmittel verdunsten.

Abschließend wurde das Schichtsystem bestehend aus SHC5020 bei 100°C für 120 Minuten im Umluft-Trockenschrank gehärtet.

**Beispiel 4d) Applikation von UVHC3000 auf die Schichtfolge aus Beispiel 1 (Vergleich)**

Die Applikation des Beschichtungsmittels UVHC3000 auf die Schicht E der Schichtfolge aus Beispiel 1 erfolgte bei 21°C und 32% relativer Feuchte durch Fluten. Während einer nachfolgenden Ablüftzeit von 2 Minuten bei zuvor genanntem Klima gefolgt von einer weiteren Ablüftzeit von 6 Minuten bei 75°C im Umluft-Trockenschrank konnten restliche in der Lackschicht enthaltene Lösungsmittel verdunsten. Abschließend erfolgte die Aushärtung der Lackschicht durch UV-Strahlung eines Hg-Strahlers in einer UV-Anlage der Firma IST (Typenbezeichnung IST M 50 2X1 URS-TR-SS) mit einer Gesamtdosis von ca. 4 $J/cm^2$ ermittelt mit einem UV-Dosimeter UV-4C SD der Firma UV-Technik Meyer GmbH.

**Beispiel 4e) Applikation von UVHC7800 auf die Schichtfolge aus Beispiel 1 (Vergleich)**

Die Applikation des Beschichtungsmittels UVHC7800 auf die Schicht E der Schichtfolge aus Beispiel 1 erfolgte bei 21°C und 32% relativer Feuchte durch Fluten. Während einer nachfolgenden Ablüftzeit von 2 Minuten bei zuvor genanntem Klima gefolgt von einer weiteren Ablüftzeit von 6 Minuten bei 75°C im Umluft-Trockenschrank konnten restliche in der Lackschicht enthaltene Lösungsmittel verdunsten. Abschließend erfolgte die Aushärtung der Lackschicht durch UV-Strahlung eines Hg-Strahlers in einer UV-Anlage der Firma IST (Typenbezeichnung IST M 50 2X1 URS-TR-SS) mit einer Gesamtdosis von ca. 4 $J/cm^2$ ermittelt mit einem UV-Dosimeter UV-4C SD der Firma UV-Technik Meyer GmbH.

Ergebnisse (V = Vergleich, E = erfindungsgemäß)

Es erfolgte die visuelle Überprüfung der Schichtfolgen aus den Beispielen 4a bis 4e nach deren Herstellung.

| Beispiel | Ergebnis der visuellen Überprüfung |
|---|---|
| 4a V | Ausbildung von Mikrorissen im Schichtaufbau |
| 4b V | Ausbildung von kleinen sternförmigen Rissen im Schichtaufbau |
| 4c E | keine Auffälligkeiten; die Oberfläche ist intakt |
| 4d V | partielle Enthaftung nach Zuschnitt |
| 4e V | keine Auffälligkeiten; die Oberfläche ist intakt, leichte Benetzungsstörungen |

Weiterhin wurden der Reflexionsindex (RI).

| Beispiel | RI |
|---|---|
| 4a V | 94,3 |
| 4b V | 96,1 |
| 4c E | 95,6 |
| 4d V | 96,5 |
| 4e V | 94,7 |

Die Proben 4c sowie 4e zeigen das die Überlackierung und Härtung der Schichtfolgen A bis E mit dem Schichtsystem F bei Temperaturen unterhalb bzw. gleich 100°C erfolgen sollte, damit ein Gesamtverbund entsteht, der keine visuellen Auffälligkeiten bei gleichzeitig hervorragenden Reflexionseigenschaften aufweist.

Die Proben 4c und 4e wurden weiterhin einer beschleunigten Alterung von 500 Stunden sowie 1000 Stunden unterzogen. Hierfür wurde ein Bewitterungsgerät der Firma Atlas (CI-Baureihe) mit nachfolgenden Parametern verwendet:

- Bestrahlungsstärke: 0,75$W/m^2$/nm bei 340nm Wellenlänge
- Filter: Boro-Boro Filter
- Schwarztafeltemperatur: 70°C
- Relative Feuchte: 50%
- keine Beregnung

| Beispiel | RI | Beobachtungen |
|---|---|---|
| 4c - 500 Stunden | 96,00 | keine Auffälligkeiten; die Oberfläche ist intakt |
| 4c - 1000 Stunden | 93,98 | keine Auffälligkeiten, die Oberfläche ist intakt |
| 4e - 500 Stunden | 96,11 | partielle Delamination |

Aus den vorliegenden Ergebnissen der Versuchsreihe 4 geht hervor, dass Schicht F bestehend aus einem anorganischen Deckschichtsystem, welches keinen UV-Absorber enthält, ein deutlich verbessertes Bewitterungsverhalten bei Belastungen nach EN ISO 62108 aufweist als ein Mehrschichtverbund, bei dem Schicht F aus einem organischen Decklack ohne UV Absorber besteht.

Anwendungstechnische Prüfungen an den Deckschichten aus den Beispielen 4a bis 4e) appliziert auf transparentem Substrat, wurden vorgenommen, im Folgenden als Beispiel 5 bezeichnet:

**Beispiel 5a) Applikation von SHP401/AS4000 auf transparentes PC-2 bei hoher Einbrenntemperatur unter Nutzung der Parameter aus Beispiel 4a.**

**Beispiel 5b) Applikation von SHP401/AS4000 auf transparentes PC-2 bei niedriger Einbrenntemperatur unter Nutzung der Parameter aus Beispiel 4b.**

**Beispiel 5c) Applikation von SHC5020 auf transparentes PC-2 bei niedriger Einbrenntemperatur unter Nutzung der Parameter aus Beispiel 4c.**

**Beispiel 5d) Applikation von UVHC3000 auf transparentes PC-2 unter Nutzung der Parameter aus Beispiel 4d.**

**Beispiel 5e) Applikation von UVHC7800 auf transparentes PC-2 unter Nutzung der Parameter aus Beispiel 4e.**

**Beispiel 5f) Schichtaufbau ohne Decklack F aus Beispiel 1**

Der Abrieb der Schichten aus den Beispielen 5a bis 5e wurde mittels Taber Industries 5151 Abraser nach 1000 Umdrehungen unter Verwendung von CS10F Rädern und einer Belastung von 500g pro Reibrad bestimmt. Die Trübungszunahme vor und nach der Belastung wurde Haze Guard von BYK Gardner ermittelt. Bei der Probe 5f wurde die Belastung nach 15 Umdrehungen beendet.

Die Aceton-Beständigkeit der Schichten aus den Beispielen 5a bis 5f wurde ermittelt. Hierfür wurde ein Wattebausch in Aceton getränkt, auf die zu prüfende Oberfläche gelegt und mit einem Uhrglas abgedeckt um die Verdunstung des Testmediums zu verhindern. Als Ergebnis wurde die Zeit angegeben, bei der die Oberfläche gerade keine Veränderung aufwies.

Die Bleistifthärte der Schichten aus den Beispielen 5a bis 5f wurde analog der ISO 15184 mit Bleistiften der Firma Cretacolor unter einer Belastung von 750g bestimmt. Als Ergebnis wurde die Bleistifthärte angegeben, bei der auf der zu prüfenden Oberfläche gerade keine Markierung erzeugt werden konnte.

| Probenummer | Abrieb-Bestimmung | Aceton-Beständigkeit | Bleistifthärte |
|---|---|---|---|
| | in [%] | in [Minuten] | [Härtegrad] |
| 5a V | 3,0 | 60 | F |
| 5b V | 7,8 | 5 | F |
| 5c E | 2,2 | 30 | F |
| 5d V | 3,9 | 60 | H |
| 5e V | 2,4 | 60 | H |
| 5f V | Schicht ist nach 15 Rotationen zerstört - vergleiche Figur 1 | <15 | <6B |

Beispiel 5 zeigt, dass ohne Decklack das Erfordernis der mechanischen Stabilität und hohen Chemikalienbeständigkeit nicht erzielt werden kann. Ungeschützte Schichtsysteme, wie im Beispiel 5f, müssen hinter einer separaten Verglasung in die jeweilige Anwendung gebracht werden.

Der hellgraue Ring in Figur 1 zeigt, dass die Schichten nach 15 Rotationen zerstört sind.

Fazit:

In der vorliegenden Erfindung ist zu erkennen, dass durch die aufgebrachten Deckschichten (Schichten F) auf den Reflexionsschichtsystemen (Schichten A bis E) langzeitstabile Reflektoren zugängig sind, die aggressiven Chemikalien sowie hoher mechanischer Beanspruchung wiederstehen können. Die Reflektivität der Aufbauten mit anorganischem Decklack ohne UV-Absorber verbleibt auch nach Belastung in Anlehnung an die DIN EN 62108 auf einem hohen Niveau.

## Patentansprüche

1. Ein Mehrschichtaufbau, enthaltend
Schicht A: eine Substratschicht, ausgewählt aus einem thermoplastischen Kunststoff, Metall oder Glas Schicht B: eine Barriereschicht, ausgewählt aus Titan oder der Gruppe der Edelmetalle.
Schicht C: metallische Reflektorschicht.
Schicht D: optional eine oxidische Schicht, ausgewählt aus Aluminiumoxid (AlOx), Titandioxid, SiO2, Ta2O5, ZrO2, Nb2O5 und HfO.
Schicht E:

    a) eine Plasmapolymerschicht (Korrosionsschutzschicht) abgeschieden aus Siloxanprecusoren ist,
    oder
    im Falle, dass Schicht D aus Aluminiumoxid oder SiO2 ist Schicht E
    b) eine hochbrechende Metalloxidschicht, wobei die Metalloxide ausgewählt sind aus Titandioxid, SiO2, Ta2O5, ZrO2, Nb2O5 und HfO oder SiO2 sein kann und optional eine weitere Schicht gemäß Schicht E (a) eine Plasmapolymerschicht aufgebracht sein kann,

    Schicht F:

    wobei Schicht F Sol-Gel-Lacke sind, die durch Hydrolyse wässriger Dispersionen von kolloidem Siliziumdioxid und einem Organoalkoxysilan und/oder einem Alkoxysilan oder Mischungen aus Organoalkoxysilanen der allgemeinen Formel RSi(OR')3 und/oder Alkoxysilanen der allgemeinen Formeln Si(OR')4 herstellt werden, wobei in den Organoalkoxysilan(en) der allgemeinen Formel RSi(OR')3 R für einen monovalenten C1 bis C6 - Alkyl-Rest oder für einen ganz oder teilweise fluorierten C1 - C6 - Alkylrest, für eine Vinyl- oder eine Allyl-Einheit, einen Arylrest oder für ein C1 - C6 Alkoxygruppe steht.erhalten werden und wobei diese Schicht F keinen UV-Absorber enthält.

2. Mehrschichtaufbau gemäß Anspruch 1, wobei der thermoplastische Kunststoff ausgewählt ist aus mindestens einem aus der Gruppe bestehend aus Polycarbonat, Polystyrol, Styrol-Copolymere, aromatische Polyester cyclische Polyolefine, Poly- oder Copolyacrylate und Poly- oder Copolymethacrylat, Copolymere mit Styrol thermoplastische Polyurethane, Polymere auf Basis von zyklischen Olefinen, Polycarbonat Blends mit olefinischen Copolymeren oder Pfropfpolymeren.

3. Mehrschichtaufbau gemäß Anspruch 1, wobei Schicht B aus Titan ist.

4. Mehrschichtaufbau gemäß Anspruch 1, wobei Schicht C aus Silber oder Silberlegierungen, wobei die Silberlegierung Anteile von kleiner 10 Gew.-% an Gold, Platin, Palladium und/oder Titan aufweist, sowie Aluminium.

5. Mehrschichtaufbau gemäß Anspruch 4, wobei Schicht C aus Silber ist.

6. Mehrschichtaufbau gemäß Anspruch 1, wobei Schicht D aus Aluminiumoxid (AlOx) oder Titandioxid ist.

7. Mehrschichtaufbau gemäß Anspruch 1,wobei Schicht E Hexamethyldisiloxan ist.

8. Mehrschichtaufbau gemäß Anspruch 1, wobei die Schichtdicken der Schichten wie folgt ist:

    Gesamtdicke der Schicht A: 1μm - 10 mm im Falle von Thermoplasten, 300 μm - 750 μm im Falle von metallischen Substraten, 750 μm - 3 mm im Falle von Glas,

Schicht B: 40 nm- 250 nm,
Schicht C: 80 nm - 250 nm,
Schicht D: 80 nm - 250 nm
Schicht E: 1 nm - 200 nm.
Schicht F: 1μm -20 μm.

**9.** Mehrschichtaufbau gemäß Anspruch 1, wobei die Schichtdicke der Schicht B 80 bis 130 nm beträgt.

**10.** Mehrschichtaufbau gemäß Anspruch 1, wobei die Schichtdicke der Schicht C 90 nm bis 160 nm, die der Schicht D 90 nm bis 160 nm beträgt und die der Schicht E 20 nm bis 100 nm beträgt.

**11.** Mehrschichtaufbau gemäß Anspruch 1, wobei der Thermoplast ausgewählt ist aus der Gruppe bestehend aus Polycarbonat, aromatischen Polyestern und Polycarbonat Blends, wobei diese Thermoplasten Füllstoffe enthalten können.

**12.** Verwendung des Mehrschichtaufbaus gemäß Anspruch 1 als Reflektor in Photovoltaikmodulen, Solarmodulen, in Beleuchtungssystemen, als Spiegel im Wohnbereich sowie im Fahrzeugbereich, als Reflektor in Lichtleitsystemen.

**13.** Photovoltaikmodule, Solarmodule, Beleuchtungssysteme, Lichtleitsysteme enthaltend einen Mehrschichtaufbau gemäß Anspruch1.

**14.** Spiegel enthaltend einen Mehrschichtaufbau gemäß Anspruch 1.

## Claims

**1.** A multilayer structure comprising
layer A: a substrate layer selected from a thermoplastic plastic, metal or glass,
layer B: a barrier layer selected from titanium or the group of the noble metals,
layer C: metallic reflector layer,
layer D: optionally an oxidic layer selected from aluminium oxide (AlOx), titanium dioxide, $SiO_2$, $Ta_2O_5$, $ZrO_2$, $Nb_2O_5$ and HfO,
layer E:

a) is a plasma polymer layer (anticorrosion layer) deposited from siloxane precursors
or
in the case where layer D is aluminium oxide or $SiO_2$, layer E is
b) a highly refractive metal oxide layer, the metal oxides being selected from titanium dioxide, $SiO_2$, $Ta_2O_5$, $ZrO_2$, $Nb_2O_5$ and HfO, or can be $SiO_2$, and a further layer according to layer E (a), a plasma polymer layer, can optionally be applied,

layer F:

wherein layer F is sol-gel lacquers which are prepared by hydrolysis of aqueous dispersions of colloidal silicon dioxide and an organoalkoxysilane and/or an alkoxysilane or mixtures of organoalkoxysilanes of the general formula RSi(OR')3 and/or alkoxysilanes of the general formula Si(OR')4, wherein in the organoalkoxysilane(s) of the general formula RSi(OR')3 R represents a monovalent C1- to C6-alkyl radical or a wholly or partially fluorinated C1-C6-alkyl radical, a vinyl unit or an allyl unit, an aryl radical or a C1-C6-alkoxy group and wherein this layer F does not contain any UV absorber.

**2.** Multilayer structure according to claim 1, wherein the thermoplastic plastic is selected from at least one of the group consisting of polycarbonate, polystyrene, styrene copolymers, aromatic polyesters, cyclic polyolefins, poly- or copolyacrylates and poly- or copoly-methacrylate, copolymers with styrene, thermoplastic polyurethanes, polymers based on cyclic olefins, polycarbonate blends with olefinic copolymers or graft polymers.

**3.** Multilayer structure according to claim 1, wherein layer B is of titanium.

**4.** Multilayer structure according to claim 1, wherein layer C is of silver or silver alloys, wherein the silver alloy comprises

amounts of less than 10 wt.% gold, platinum, palladium and/or titanium, as well as aluminium.

5. Multilayer structure according to claim 4, wherein layer C is of silver.

6. Multilayer structure according to claim 1, wherein layer D is of aluminium oxide (AlOx) or titanium dioxide.

7. Multilayer structure according to claim 1, wherein layer E is hexamethyldisiloxane.

8. Multilayer structure according to claim 1, wherein the layer thicknesses of the layers are as follows:

total thickness of layer A: from 1 m to 10 mm in the case of thermoplastics, from 300 m to 750 m in the case of metallic substrates, from 750 m to 3 mm in the case of glass,

layer B: from 40 nm to 250 nm,
layer C: from 80 nm to 250 nm,
layer D: from 80 nm to 250 nm,
layer E: from 1 nm to 200 nm,
layer F: from 1 m to 20 m.

9. Multilayer structure according to claim 1, wherein the layer thickness of layer B is from 80 to 130 nm.

10. Multilayer structure according to claim 1, wherein the layer thickness of layer C is from 90 nm to 160 nm, the layer thickness of layer D is from 90 nm to 160 nm, and the layer thickness of layer E is from 20 nm to 100 nm.

11. Multilayer structure according to claim 1, wherein the thermoplastic is selected from the group consisting of polycarbonate, aromatic polyesters and polycarbonate blends, wherein these thermoplastics can comprise fillers.

12. Use of the multilayer structure according to claim 1 as a reflector in photovoltaic modules, solar modules, in lighting systems, as a mirror in the residential field as well as in the automotive field, as a reflector in fibre-optic systems.

13. Photovoltaic modules, solar modules, lighting systems, fibre-optic systems comprising a multilayer structure according to claim 1.

14. Mirror comprising a multilayer structure according to claim 1.

## Revendications

1. Structure multicouche, contenant :

couche A : une couche de substrat, choisie parmi un plastique thermoplastique, un métal ou le verre,
couche B : une couche de barrière, choisie parmi le titane ou le groupe des métaux nobles,
couche C : une couche de réflecteur métallique,
couche D : éventuellement une couche oxydique, choisie parmi l'oxyde d'aluminium ($AlO_x$), le dioxyde de titane, $SiO_2$, $Ta_2O_5$, $ZrO_2$, $Nb_2O_5$ et HfO,
couche E :

a) une couche de polymère plasma (couche anticorrosion) déposée à partir de précurseurs de siloxane, ou
lorsque la couche D est en oxyde d'aluminium ou $SiO_2$, la couche E peut être
b) une couche d'oxyde métallique d'indice de réfraction élevé, les oxydes métalliques étant choisis parmi le dioxyde de titane, $SiO_2$, $Ta_2O_5$, $ZrO_2$, $Nb_2O_5$ et HfO, ou $SiO_2$, et une couche supplémentaire selon la couche E (a) une couche de polymère plasma peut éventuellement être appliquée,

couche F :

la couche F est un vernis sol-gel, qui est fabriqué par hydrolyse de dispersions aqueuses de dioxyde de silicium colloïdal et d'un organoalcoxysilane et/ou d'un alcoxysilane ou de mélanges d'organoalcoxysilanes

de formule générale $RSi(OR')_3$ et/ou d'alcoxysilanes de formule générale $Si(OR')_4$ ; dans le(s) organoalcoxysilane(s) de formule générale $RSi(OR')_3$, R représentant un radical alkyle en C1 à C6 monovalent ou un radical alkyle en C1-C6 totalement ou partiellement fluoré, une unité vinyle ou allyle, un radical aryle ou un groupe alcoxy en C1-C6, et cette couche F ne contient pas d'absorbeur UV.

**2.** Structure multicouche selon la revendication 1, dans laquelle le plastique thermoplastique est choisi parmi au moins un du groupe constitué par le polycarbonate, le polystyrène, les copolymères de styrène, les polyesters aromatiques, les polyoléfines cycliques, les poly- ou copolyacrylates et les poly- ou copolyméthacrylates, les copolymères avec du styrène, les polyuréthanes thermoplastiques, les polymères à base d'oléfines cycliques, les mélanges de polycarbonate avec des polymères greffés ou des copolymères oléfiniques.

**3.** Structure multicouche selon la revendication 1, dans laquelle la couche B est en titane.

**4.** Structure multicouche selon la revendication 1, dans laquelle la couche C est en argent ou en alliages d'argent, l'alliage d'argent comprenant des proportions inférieures à 10 % en poids d'or, de platine, de palladium et/ou de titane, ainsi que d'aluminium.

**5.** Structure multicouche selon la revendication 4, dans laquelle la couche C est en argent.

**6.** Structure multicouche selon la revendication 1, dans laquelle la couche D est en oxyde d'aluminium ($AlO_x$) ou en dioxyde de titane.

**7.** Structure multicouche selon la revendication 1, dans laquelle la couche E est en hexaméthyldisiloxane.

**8.** Structure multicouche selon la revendication 1, dans laquelle les épaisseurs de couche des couches sont les suivantes :

épaisseur totale de la couche A : 1 μm à 10 mm dans le cas de thermoplastiques, 300 μm à 750 μm dans le cas de substrats métalliques, 750 μm à 3 mm dans le cas de verre,

couche B : 40 nm à 250 nm,
couche C : 80 nm à 250 nm,
couche D : 80 nm à 250 nm,
couche E : 1 nm à 200 nm,
couche F : 1 μm à 20 μm.

**9.** Structure multicouche selon la revendication 1, dans laquelle l'épaisseur de couche de la couche B est de 80 à 130 nm.

**10.** Structure multicouche selon la revendication 1, dans laquelle l'épaisseur de couche de la couche C est de 90 nm à 160 nm, de la couche D de 90 nm à 160 nm, et de la couche E de 20 nm à 100 nm.

**11.** Structure multicouche selon la revendication 1, dans laquelle le thermoplastique est choisi dans le groupe constitué par le polycarbonate, les polyesters aromatiques et les mélanges de polycarbonate, ces thermoplastiques pouvant contenir des charges.

**12.** Utilisation de la structure multicouche selon la revendication 1 en tant que réflecteur dans des modules photovoltaïques, des modules solaires, dans des systèmes d'éclairage, en tant que miroir dans le domaine résidentiel, ainsi que dans le domaine automobile, en tant que réflecteur dans les systèmes de conduits de lumière.

**13.** Modules photovoltaïques, modules solaires, systèmes d'éclairage, systèmes de conduits de lumière contenant une structure multicouche selon la revendication 1.

**14.** Miroir contenant une structure multicouche selon la revendication 1.

Figur 1

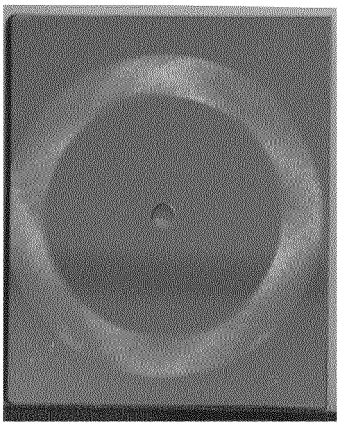

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2000007818 A
- US 6078425 A
- EP 1657281 A
- EP 1582549 A1
- WO 2008037364 A1
- WO 2006040087 A
- DE 2035390 A
- US PS3644574 A
- DE 2248242 A
- GB 1409275 A
- EP 0839623 A
- WO 9615102 A
- EP 0500496 A
- WO 2008109072 A


### In der Beschreibung aufgeführte Nicht-Patentliteratur


- *Tantaloxidschichten soll in Society of Vacuum Coaters,* 2009, 473-477
- *Society of Vacuum Coaters,* 2009, 473-477
- *Aus Concentrating Photovoltaic Conference,* April 2011, vol. 7
- **ULLMANNS.** *Enzyklopädie der Technischen Chemie,* 1980, vol. 19, 280 ff
- **HANS ZWEIFEL.** Plastics Additives Handbook. Hanser Verlag, 2000
- Diese Verfahren sind allgemein bekannt und zum Beispiel beschrieben in Vakuumbeschichtung. VDI Verlag, 1995, vol. 1-5
- **H. FREY.** Vakuumbeschichtung. VDI-Verlag Düsseldorf, 1995, vol. 1 bis 5
- **R.A. HAEFER.** Oberflächen- und Dünnschicht-Technologie. Springer Verlag, 1987
- **FRIEDRICH ; H. GRÜNWALD et al.** Metallized plastics 5 & 6: Fundamental and applied aspects. *Surface and Coatings Technology,* 1999, vol. 111, 287-296
- Das Verfahren ist unter anderem beschrieben. *Surface and Coatings Technology,* 1999, vol. 111, 287-296
- **RALPH K. ILER.** The Chemistry of Silica. John Wiley & Sons, 1979, 312-461